# EUROPEAN PATENT APPLICATION

(11) **EP 0 732 623 A2**
(43) Date of publication of application: **18.09.1996**
(21) Application number: 96103953.4
(22) Date of filing: 13.03.1996
(51) Int. Cl.: G03F 3/10

(54) **Positive-acting photosensitive element**

(30) Priority: 13.03.1995 US 402628
(71) Applicant: MINNESOTA MINING AND MANUFACTURING COMPANY, St. Paul, Minnesota 55133-3427 (US)
(72) Inventor: Lundquist, Wallace R., c/o Minnesota Min & Man Co., Saint Paul, Minnesota 55133-3427 (US); Baldock, Terence W., c/o Minnesota Min & Man Co., Saint Paul, Minnesota 55133-3427 (US)
(74) Representative: VOSSIUS & PARTNER

(57) **Abstract**

A positive-acting photosensitive element comprising:
(a) a release layer;
(b) a photosensitive layer comprising a positive-acting photosensitizer and a copolymer comprising acrylic acid or methacrylic acid moieties, which photosensitive layer is soluble in an aqueous solution having a pH of from about 8.4 to 9.8; and
(c) an adhesive layer.

## Description

The present invention relates to the photomechanical production of multi-colored images on a single sheet or substrate without printing. The invention has particular application in the proofing of color separation positives preparatory to multi-colored lithographic reproduction.

In printing pictorial matter, whether by lithography, letterpress, or gravure, the half-tone process is used, wherein the actual printed image is composed of thousands of minute dots per square inch of a single color ink of varied dot size or ink density. What the naked eye sees as shading in half tone prints is actually a controlled variation in the size of dots relative to the unprinted areas between the dots. In black and white pictorial matter, the dots are printed in black ink only. Full color reproductions, however, are necessarily printed in each of at least three colors, cyan, magenta, and yellow (known as "three color process"), or in these same colors with the addition of black (known as "four-color process"). For each color, a printing plate is made. In order to make the three or four printing plates, the original color picture or photograph is "separated" photographically, with the use of filters, masks, etc., into a set of three or four half-tone positives, each representing one of the colors, and containing, dot for dot, the amount of that color that must be printed to produce the desired total color print. The preparation of the color-separation positive is an art and requires considerable skill in handling the many variables to produce a desired result. Often, trial and error is involved, thereby requiring correction or replacement of one or more of the positives. Unless some reliable system is available to "proof" the positives, the printing press must be set up and copy printed just to secure preliminary proofs. This is time consuming and costly. It is therefore desirable to provide accurate means for proofing the positives without printing.

In the known surprint type color-proofing method, a color-proofing sheet is prepared by successively producing prints of different colors on an opaque support from different color-separation films, respectively, while applying photosensitive solutions of corresponding colors on the opaque support in succession.

In the known overlay type color-proofing method, an independent transparent plastic support is used for producing a print of each color-separation film by applying a photosensitive solution of the corresponding color, and a plurality of such supports carrying prints of corresponding colors are superposed with each other on a white sheet to produce a color-proofing sheet.

These methods are further described in U.S. Patent Nos. 3,721,557 and 4,482,625, both of which are incorporated herein by reference.

One system for proofing color separation positives is disclosed in U.S. Patent No. 4,260,673. However, this system has the drawback of creating waste products in amounts that exceed the limits being set in some communities around the world. These waste products include highly alkaline developers and phenolic resins. It is desirable to reduce effluent emissions, including the high alkalinity of these development solutions.

U.S. Patent Nos. 4,659,642; 4,772,533; and 4,937,168 disclose proofing element comprising carrier layer, release layer and photosensitive diazo oxide layer with a binder. These references do not show acrylic resin binders in the photosensitive layer and do not show barrier layers or the preferred compositions for those barriers layers. These elements were developed at pH levels above 11.0.

This invention provides a positive-acting photosensitive element that can be used to prepare a multi-colored color proof. The positive-acting photosensitive element of the present invention is also developable by more moderate levls of pH developing solutions (e.g., below pH of 10, more preferably with solutions having a pH between 8.4 and 9.8). In one aspect of the invention, the element respectively comprises the following layers from top to bottom:
(a) a release layer;
(b) a photosensitive layer comprising a photosensitizer and a copolymer comprising acrylic acid or methacrylic acid moieties, which layer is preferably free of phenolic resin and is soluble in an aqueous solution having a pH of from about 8.4 to about 9.8; and
(c) an adhesive layer.
Preferably, a carrier layer is in contact with the surface of the release layer opposite the surface bearing the photosensitive layer. The carrier layer is usually removed from the element prior to exposure and development of the element.

The terminology used in the description of the present invention that the binder or layer is "soluble in an aqueous solution of pH 8.4 to 9.8" means that the layer or material is soluble under reasonable conditions in a reasonable amount of time. When, for example, a layer is being considered, solubility means that a 0.75 micrometer thick layer can be removed into a developer solution having a pH of 9.7 under the following conditions:
1) the developer is applied at 0.14 ml of solution per square inch of surface area of coating,
2) the developer is at slightly elevated room temperature, 26.5-27.0 degrees Celsius,
3) the developer soak time is 2-4 seconds (preferably 2.5 seconds),
4) physical agitation and contact development is by rotary polymeric brushes for 1-3 seconds (preferably 1.2 seconds), and
5) the developer solution comprises 1.0 grams potassium carbonate, 1.0 grams sodium bicarbonate, 0.1 grams surfactant (e.g., Triton DF-016) in 97.9 grams of deionized water.

The photosensitive layer (b) is disposed between the release layer (a) and adhesive layer (c). The photosensitive element may optionally comprise a preferred barrier layer disposed between the photosensitive layer and the adhesive layer. The barrier layer is intended to prevent migration of components from one of these layers to the other. The photosensitive layer can contain a colorant, e.g., a pigment or a dye. The element may contain an optional colorant-containing layer disposed between the photosensitive layer and the barrier layer (if a barrier layer is present) or between the photosensitive layer and the adhesive layer (if a barrier layer is not present). If the optional colorant-containing layer is used, the photosensitive layer should not contain a colorant.

In another aspect of the invention, the element comprises the following layers:
(a) a carrier layer, and
(b) a photosensitive layer comprising a photosensitizer and a copolymer containing acrylic acid or methacrylic acid moieties, which photosensitive layer is preferably free of phenolic resin and is soluble in an aqueous solution having a pH of from about 8.4 to about 9.8.
The carrier layer is not necessarily removed prior to exposure and development of the element.

The photosensitizer of the photosensitive layer is preferably a radiation-sensitive, including light-sensitive diazo compound. This compound preferably contains a naphthoquinone-diazide-sulfonate ester moiety corresponding to the formula 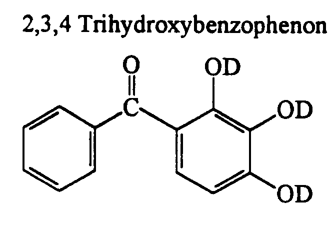 where D is: H, or 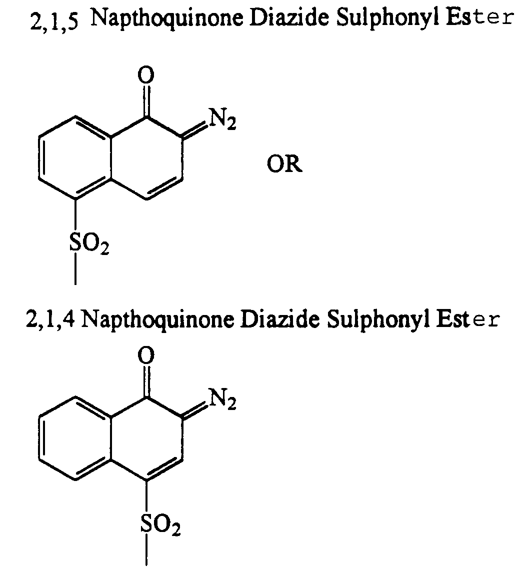 where at least one D independently represents a 2-diazo-naphthalene-1-one-4-sulfonyl or 2-diazo-naphthalene-1-one-5-sulfonyl radical; D also independently represents a hydrogen. Representative examples of light-sensitive positive-acting diazo compounds include the mixed esters of 2,3,4-trihydroxybenzophenone and 2-diazo-naphthalene-1-one-5-sulfonyl chloride.

The photosensitive layer must contain a resin having a solubility property that will allow the use of a developer having a relatively low pH, e.g., less than about 9.8, preferably as low as about 8.4 or even lower, if possible. Examples of resins that are preferred for the photosensitive layer include copolymers of styrene and acrylic acid or methacrylic acid. The photosensitive layer is preferably free of phenolic resin for environmental reasons.

The photosensitive element of the present invention can be used to prepare surprint color proofs and overlay color proofs.

In one class of the invention, the photosensitive element of the present invention comprises: (1) a release layer; (2) a photosensitive layer; (3) optionally, a colorant layer if there is no colorant in the photsensitive layer; (4) optionally, a barrier layer; and (5) an adhesive layer. In another class of the invention, the photosensitive element of the invention comprises: (1) a photosensitive layer; (2) optionally, a colorant layer; and (3) a carrier layer.

In the first class of the invention, the element is generally supported by a carrier layer, which is in face-to-face contact with the release layer. The carrier layer is removed prior to exposure and development of the element.

In one embodiment of one class of the invention, the element comprises, from top to bottom, a carrier layer, a release layer, a photosensitive layer, and an adhesive layer. In another embodiment of that class of the invention, the element comprises, from top to bottom, a carrier layer, a release layer, a photosensitive layer, a barrier layer, and an adhesive layer. In a third embodiment of that class of the invention, the element comprises, from top to bottom, a carrier layer, a release layer, a photosensitive layer, a colorant layer, a barrier layer, and an adhesive layer. In a fourth embodiment of that class of the invention, the element comprises, from top to bottom, a carrier layer, a release layer, a photosensitive layer, a colorant layer, and an adhesive layer. In one embodiment of the second class of the invention, the element comprises, from top to bottom, a carrier layer and a photosensitive layer. In another embodiment of that class, the element comprises, from top to bottom, a carrier layer, a colorant layer, and a photosensitive layer.

The components of the various embodiments will be described in detail.

### Carrier Film

The carrier film is a temporary support onto which the release layer is coated. The carrier film is typically formed from a dimensionally and chemically stable material. Such materials are well-known in the art. Materials that are suitable for the carrier film include polyethylene terephthalate and polyethylenenaphthalate, typically having a thickness of from about 1 to about 7 mils.

### Release Layer

The release layer allows the element to be easily removed from the carrier film upon which it has been applied. The carrier film is generally removed after the element has been laminated to a receptor sheet. A preferred release layer consists of a blend of poly(vinyl alcohol) ("Airvol 205" and "Airvol 540", available from Air Products and Chemicals Inc.) Other materials suitable as additives for preparing the release layer include hydrophilic polymers such as polyvinyl pyrrolidone . The release layer also includes a surfactant to aid coatability and releasability. An example of such a surfactant is "TRITON X-100", available from Rohm & Haas. The amount of surfactant can range from about 0.5% to about 10.0% by weight, preferably from about 6.0% to about 8.0% weight, based on the weight of the release layer.

### Photosensitive Layer

The photosensitive layer can contain a colorant, but is not required to do so. It is preferred that the photosensitive layer contain a colorant. The photosensitizer is preferably a light sensitive naphthoquinone diazide. Particularly useful quinone diazide positive-acting photosensitizer are the ester of 2,3,4-trihydroxy benzophenone and 2-diazo-naphthalene-1-one-5-sulfonyl chloride as taught in U.S. Patent Nos. 4,266,001; 3,106,365; 3,148,983; and 3,201,239. Other suitable photosensitizers are taught in U.S. Patent Nos. 4,436,804. The diazo compounds of choice are preferably soluble in organic solvents. The photosensitizer may include one or a mixture of diazo compounds. All of the foregoing patents are incorporated herein by reference. The preferred light-sensitive compounds for use in this layer include esters of naphthoquinone diazide. The most preferred light-sensitive compound is actually a mixture of esters of 2,3,4-trihydroxy-benzophenone with either 2-diazo-naphthalene-1-one-5-sulfonyl chloride or 2-diazo-naphthalene-1-one-4-sulfonyl chloride. Other 2,1,5 or 2,1,4 quinone diazide esters such as those derived from tert-butylphenol, dihydroxybenzophenone, and bisphenol A can be used. These esters are commercially available from International Photochemicals Co.

In the photosensitive layer, the major amount of resins (at least 50% by weight of the resins) must be soluble in a solution having a pH no greater than about 9.8, preferably no less than about 8.4. It has been found that resins having an acid number ranging from about 3 to about 250, preferably from about 130 to about 250, more preferably from about 140 to about 240 are particularly useful as the major resinous component of the photosensitive layer. The acid number of the resin must be sufficiently high that the resin will be capable of dissolving in an aqueous solution having a pH no greater than about 9.8, but it also must be sufficiently low that the resin will not be adversely affected by moisture in the ambient environment. Resins that are suitable as the major resinous component of the photosensitive layer of the element of the present invention include copolymers of acrylic acid or methacrylic acid with one or more of the following monomers:
2-Ethoxyethyl acrylate
2-Ethoxyethyl methacrylate
Methyl acrylate
Methyl methacrylate
n-Butyl acrylate
n-Butyl methacrylate
Ethyl acrylate
Pentaethyleneglycol methacrylate
Decaethyleneglycol methyacrylate
Didecylethyleneglycol methacrylate
2-Hydroxyethyl acrylate
2-Hydroxyethyl methacrylate
3-Chloro-2-hydroxypropyl methacrylate
Hexafluoro-1,1-3-trihydrobutyl acrylate
Trifluoroethyl acrylate
Acrylamide
N-(1,1-dimethyl-3-oxobutyl)acrylamide
Styrene
The preferred resins are copolymers of styrene and acrylic acid or methacrylic acid. Commercially available examples of copolymers of styrene and acrylic acid or methacrylic acid that are useful in this invention include:

| Trademark of resin | Molecular weight | Acid number |
|---|---|---|
| "JONCRYL 67" | 10,000 | 190 |
| "JONCRYL 586" | 3,700 | 105 |
| "JONCRYL 587" | 5,400 | 3/92* |
| "JONCRYL 611" | 8,100 | 55 |
| "JONCRYL 678" | 8,000 | 200 |
| "JONCRYL 680" | 4,900 | 215 |
| "JONCRYL 682" | 1,700 | 235 |
| "JONCRYL 683" | 8,000 | 160 |
| "JONCRYL 690" | 15,500 | 232 |

| | | |
|---|---|---|
| * 3/92 is the acid/hydroxyl number. | | |

These resins are available from S.C. Johnson & Son, Inc.

Other commercially available resins that can be used in combination with (or where appropriate as) the acrylic polymers described above for the binder in the photosensitive layer have the following trade designations:

| Trademark of resin | Type of resin | Source of resin |
|---|---|---|
| "CARBOSET 525" | Acrylate polymer | The B.F. Goodrich Co. |
| "CARBOSET 1160" | Copolymer of styrene and acrylic acid | The B.F. Goodrich Co. |
| "SCRIPSET 540" | Ester of styrene/maleic anhydride polymer | Monsanto Co. |
| "GANTREZ ES-435" | Ester of ethylvinylether/maleic anhydride copolymer | International Specialty Products Inc. |
| "VINAC ASB 516" | Vinylacetate polymer | Air Products and Chemicals, Inc. |
| "PVP K-90" | Polyvinylpyrrolidone | International Specialty Products Inc. |
| acidified "BUTVAR B-98" | Polyvinylbutyral modified by addition of succinic anhydride and triethylamine | Monsanto Co. |

The colorant can comprise at least one dye or at least one pigment or both. Preferred colorants are pigments that can be finely dispersed to give highly transparent color layers. Any dye that is soluble in the coating solvent and does not adversely affect the light sensitivity of the layer of photosolubilizable material, inhibit the photosolubilization reaction, or migrate excessively into adjacent layers, is suitable for this invention. Pigments can be selected from those types that are commercially available for matching color specifications established by the color printing industry. Pigments are preferred as colorants in solubilizable compositions, and, more particularly, in photosolubilizable compositions used in color proofing applications. Pigments are preferred because they have a lower tendency than dyes to migrate between layers. The pigments are preferably ground to submicron size in a dispersing resin, such as polyvinylbutyral and a dispersing aid, such as one having the trade name "DISBERBYK 161", available from BYK-Chemie USA.

The pigment(s) can be dispersed by milling the pigment(s) in the photosensitive material of the photosensitive layer. More preferably, the pigment(s) can be dispersed by milling the pigment(s) in a dispersing resin or combination of resins and then adding the resulting dispersion to the photosensitive composition. The particular type of dispersing resin and the ratio of pigment to resin chosen will depend on the particular pigment, surface treatment of the pigment, dispersing solvent, milling process, and the quality of dispersion required.

Pigments that can be used in the present invention include, but are not limited to:
Yellow pigment GRL-01 (Hoechst AG)
Magenta pigment HC-137019 (Hoechst AG)
Cyan pigment 248-0615 (Sun Chemical Co.)
Black pigment Raven 760 (Columbia Chemical Co.)

Solvent-soluble dyes that can be used in the present invention include, but are not limited to:
Orasol Red G (Ciba-Geigy Corporation)
Microlith Blue 4G-T (Ciba-Geigy Corporation)
Solvents suitable for dissolving these dyes include, but are not limited to alcohols and ketones.

The colorant can be incorporated in the photosensitive layer, but need not be, depending on the construction of the element. In the preferred construction, the colorant is incorporated in the photosensitive layer.

A colorant layer independent of the photosensitive layer is optional. If a separate colorant layer is used, the layer must be soluble in the developer. The material of the independent colorant layer is finely dispersed in one or more developer-soluble resins. If an independent colorant layer is used, the photosensitive layer should not contain a colorant.

### Barrier Layer

A barrier layer is optional. The preferred embodiments of the photosensitive element include a barrier layer. When present, it is preferred that the barrier layer comprise one or more polymers having a) acrylic moieties, preferably styrene and acrylic acid or styrene and methacrylic acid monomeric units. A commercially available example of such a preferred polymer has the trade name "JONCRYL 680" (S.C. Johnson & Son, Inc.). The barrier layer can be used to control photospeed, micro line resolution, dot gain, and background cleanout by varying the alkali solubility or the thickness or both alkali solubility and thickness of the barrier layer. Resins that can be used in the barrier layer include acrylic resins (e.g., "CARBOSET 525", The B.F. Goodrich Co.); esters of styrene/maleic anhydride copolymer (e.g., "SCRIPSET 640", Monsanto Co.); polyvinylpyrrolidone (e.g., "PVP K-90", International Specialty Products Inc.); and vinylacetate polymers (e.g., "VINAC ASB 516", Air Products and Chemicals, Inc.).

### Adhesive Layer

Adhesive layers are used to bond the first photosensitive element onto the receiver sheet and each succeeding photosensitive element to the photosensitive layer of the preceding photosensitive element. The adhesive can be activated by heat or pressure or both. To prevent blocking during storage, the adhesive should be non-tacky at temperatures below 60°C. A preferred adhesive for the adhesive layer comprises an acrylic latex, such as "DL-0777", commercially available from Reichhold Chemicals, Inc., and anti-blocking beads, such as polymethylmethacrylate beads such as those described in U.S. Patent No. 4,885,225. Surfactants and plasticizers can also be employed in the adhesive layer for the purpose of improving coatability and flexibility. Other materials, such as opacifying agents, can be used in the adhesive layer. Materials that are suitable for the adhesive layer include naphthalene sulfonate formaldehyde condensate dispersants ("DAXAD 11KLS", W.R. Grace & Co.); tetrafunctional block copolymer surfactant ("TETRONIC 701", BASF Corporation); styrene butadiene copolymer ("PLIOLITE S5A", The Goodyear Tire and Rubber Company); vinylacetate copolymer ("LATEX 40100", Reichhold Chemicals, Inc.); and carboxylated acrylate ("LATEX 40504", Reichold Chemicals, Inc.).

The photosensitive element of this invention is especially valuable in preparing multiple-layer, light-sensitive articles that can be used to produce four-color proofs. Such articles, which comprise a plurality of photosensitive elements, are described in U.S. Patent Nos. 4,260,673 and 3,649,268, both of which are incorporated herein by reference.

As described previously, the photosensitive element comprises, in order, a carrier support, a release layer overlying the support, a layer of photosensitive, i.e., photosolubilizable, material overlying the release layer, an optional barrier layer, and a layer of adhesive, preferably thermoplastic resin, overlying the layer of photosensitive material. In one process, known as the surprint process, the photosensitive element is laminated to a receptor sheet via the layer of adhesive. The carrier support is then peeled away, usually manually. The layer of photosensitive material is then imagewise exposed to actinic radiation. The release layer and the exposed areas of the colored layer of photosensitive material are then dissolved away with a developer solution, thereby leaving a colored image disposed on the receptor sheet. Each of these steps is then repeated at least once for a different color, with the exception that each subsequent photosensitive element is applied over the previous colored image on the same side of the receptor sheet, rather than to the receptor sheet itself. In the usual case, four photosensitive elements are employed to produce a four-color proof. The colors consist of cyan, magenta, yellow, and black.

Multiple-layer photosensitive elements suitable for the surprint color-proofing method can be prepared according to the following procedure:

Release layer: The composition for preparing the release layer can be machine coated onto a clear 2.0 mil polymeric, preferably polyester, carrier film and dried to give a release layer having a dry coating weight of 0.015 to 0.095 g/ft² , preferably 0.025 to 0.035 g/m².

Photosensitive layer: The composition for preparing the photosensitive layer can be coated onto the release layer by means of a wire wound rod and dried for 2 to 3 minutes at a temperature of 200 to 210°F to give a layer of photosensitive material having a dry coating weight of 0.030 to 0.100 g/ft², preferably 0.065 to 0.090 g/m².

Barrier Layer: The composition for preparing the barrier layer can be coated onto the layer of photosensitive material by means of a wire wound rod and dried at a temperature of 200 to 210°F for 2 to 3 minutes to give a layer of resin having a dry coating weight of 0.005 to 0.050 g/ft², preferably 0.010 to 0.020 g/m².

Adhesive Layer: The composition for preparing the adhesive layer can be coated onto the barrier layer by means of a wire wound rod and dried at a temperature of 200 to 210 °F for 2 to 4 minutes to give a layer of resin having a dry coating weight of 0.100 to 2.00 g/ft². The actual coating weight can vary and is dictated by the requirements of the user.

Each individual sample can be laminated to an opaque, white base (e.g., 3M "MATCHPRINT" Base-commercial, Minnesota Mining and Manufacturing Company), by means of a laminator (e.g., 3M MR 447 "MATCHPRINT", Minnesota Mining and Manufacturing Company), whereby the layer of adhesive comes in contact with the white base. The laminate is allowed to cool, and the polymeric film, which was a carrier, can be removed by stripping it from the laminate with fracture occurring at the interface of the release layer/polymeric film. The laminate can be exposed for 10 to 30 seconds with a Berkey vacuum exposure frame fitted with a 5 kw combination bulb. Exposure renders the light-struck areas of the photosensitive layer soluble.

Each exposed sample can be processed, i.e., the light-struck areas of the exposed photosensitive layer can be removed, by means of a processor (3M Model 2340) with a developer solution. The photosolubilized material can also be removed by wiping with a cotton pad saturated with the developer solution. In the unexposed, i.e., non-light-struck areas, only the release layer can be washed off and three layers of undissolved materials remain, i.e., the non-light-struck areas of the photosensitive layer, the barrier layer, and the adhesive layer. In the exposed, i.e., light-struck, areas, the release layer, the layer of photosolubilized material, and the barrier layer can be washed off during processing with only the layer of adhesive remaining adhered to the white base.

Each of the foregoing steps can be repeated for a different color, whereby the colored image of the next photosensitive element is applied over the previous colored image on the image-bearing side of the receptor sheet. In the usual case, four photosensitive elements are employed to produce a four-color proof. The colors typically consist of cyan, magenta, yellow, and black.

Photosensitive elements suitable for the overlay method of color proofing do not require the adhesive layer and release layer, because the print-carrying supports are merely superposed with each other.

Preferred embodiments of the inventive positive acting photosensitive elements are described in claims 1 to 14.

In the following examples, all parts and percentages are based on weight unless indicated otherwise. The following trademarks and tradenames are owned by the companies indicated.

| Trademark or tradename | Company |
|---|---|
| "AIRVOL 205" | Air Products and Chemicals, Inc. |
| "AIRVOL 540" | Air Products and Chemicals, Inc. |
| "TRITON X-100" | Rohm and Haas Co. |
| "TRITON DF016" | Rohm and Haas Co. |
| "DOWANOL PM" | DowChemical USA |
| "JONCRYL 587" | S.C. Johnson & Son, Inc. |
| "JONCRYL 67" | S.C. Johnson & Son, Inc. |
| "JONCRYL 586" | S.C. Johnson & Son, Inc. |
| "JONCRYL 680" | S.C. Johnson & Son, Inc. |
| "JONCRYL 690" | S.C. Johnson & Son, Inc. |
| "BUTVAR B-98" | Monsanto Co. |
| "DISBERBYK 161" | BYK-Chemie USA |
| "FC 55/35/10" | 3M Co. |
| Yellow GRL-01 | Hoechst AG |
| Magenta HC-137019 | Hoechst AG |
| Cyan 248-0615 | Sun Chemical Co. |
| Black Raven 760 | Columbia Chem. Co. |
| "DL-0777" | Reichold Chem. Co. |
| "TETRONIC 701" | BASF Corporation |
| "DAXAD 11KLS" | W.R. Grace & Co. |
| "ELVACITE AB1015" | E.I. duPont de Nemours |

### Example 1

This example illustrates preparation of a four-color surprint proof.

A solution consisting of the following ingredients in the amounts indicated was prepared:

| Ingredient | Amount (g) |
|---|---|
| Polyvinyl alcohol ("AIRVOL 205") | 1.00 |
| Polyvinyl alcohol ("AIRVOL 540") | 1.00 |
| Surfactant ("TRITON X-100") | 0.01 |
| Deionized Water | 97.99 |

The solution was coated onto untreated polyester film (polyethylene terephthalate film having a thickness of 0.002 inch) by means of a wire wound rod to form a release layer. The dried layer had a coating weight of about 0.080 g/sq.ft.

Formulations for solutions of photosensitive material containing a single colorant were prepared. These formulations contained the following ingredients in the amounts indicated.

| Ingredient | Amount (g) Color of photosensitive layer | | | |
|---|---|---|---|---|
| | Yellow | Magenta | Cyan | Black |
| Diazo-oxide¹ | 90.45 | 94.53 | 129.96 | 137.43 |
| Methyl ethyl ketone | 1369.00 | 705.00 | 1420.00 | 1445.00 |
| 1-methoxy-2-propanol² | 1369.00 | 2116.00 | 1420.00 | 1445.00 |
| Styrene/acrylic acid copolymer³ | 76.00 | 7.20 | 96.72 | 39.00 |
| Styrene/acrylic acid copolymer⁴ | 89.86 | 62.21 | 57.00 | 100.73 |
| Polyvinyl butyral⁵ | 8.13 | 11.62 | ----- | ----- |
| 30% solution of a blocked copolymer⁶ | 3.90 | 8.90 | 6.84 | 12.09 |
| Octylphenoxypolyethoxyethanol nonionic surfactant⁷ | 2.40 | 2.60 | 2.80 | 3.10 |
| 15% n-ethyl perfluorooctane sulfonamidoethylmethacrylate, 35% butylmethacrylate, 10% acrylic acid⁸ | 0.90 | 0.90 | 0.90 | 0.90 |
| Yellow Pigment⁹ | 32.51 | ----- | ----- | ----- |
| Magenta pigment¹⁰ | ----- | 73.35 | ----- | ----- |
| Cyan pigment¹¹ | ----- | 0.72 | 57.00 | 20.14 |
| Black Pigment¹² | ----- | ----- | ----- | 80.59 |
| Desired Optical Density | 0.90 | 1.20 | 1.20 | 1.60 |

| | | | | |
|---|---|---|---|---|
| ¹The diazo-oxide was 2,3,4-trihydroxybenzophenone esterified with naphthalene-(1,2)-diazido-(2)-5-sulphonylchloride, available from International Photochemicals Inc. | | | | |
| ²"DOWANOL PM" | | | | |
| ³"JONCRYL 587" | | | | |
| ⁴"JONCRYL 690" | | | | |
| ⁵"BUTVAR B-98" | | | | |
| ⁶"DISPERBYK 161" | | | | |
| ⁷"TRITON X-100" | | | | |
| ⁸"FC 55/35/10" | | | | |
| ⁹Yellow GRL-01 | | | | |
| ¹⁰Magenta HC-137019 | | | | |
| ¹¹Cyan 248-0615 | | | | |
| ¹²Black Raven 760 | | | | |

The pigments were first dispersed in a mixture comprising a copolymer of styrene and acrylic acid, polyvinyl butyral, 30% solution of a blocked copolymer, methyl ethyl ketone, and 1-methoxy-2-propanol. The dispersion containing the pigment was then added to the coating solvent. The pigment particles were submicron in size so that the photosensitive layer would be transparent.

Each of the solutions of photosensitive material was coated onto the exposed surface of the release layer by means of an appropriate coating rod. A sufficient amount of each coating solution was used to give the desired optical density. The dry coating weights were about 0.060 g/sq. ft.

A composition for preparing the barrier layer was prepared. The composition consisted of the following ingredients in the amounts indicated:

| Ingredient | Amount (g) |
|---|---|
| Deionized Water | 2615.00 |
| 30% aqueous ammonium hydroxide | 85.00 |
| Styrene/acrylic acid copolymer | 300.0 |

After the copolymer of styrene and acrylic acid had been dissolved, the pH of the solution was adjusted to 7.5 with 38.0 g of 37% aqueous hydrochloric acid that has been diluted with 600 grams of deionized water. The solution for the barrier layer was coated over the dried photosensitive layer to give a dry coating weight of about 0.010 g/sq. ft.

A solution containing a thermally activatable adhesive was coated over the dried barrier layer. Either of two separate adhesive formulas can be used.

| Ingredient | Amount (g) | |
|---|---|---|
| | I | II |
| Deionized water | 500.00 | 1525.00 |
| 45% aqueous acrylic latex ("DL-0777") | 1000.00 | 1000.00 |
| Tetrafunctional block copolymer | 1.50 | 0.80 |
| Polymethyl methacrylate beads (25% dry solids) | 3.60 | 5.40 |
| Naphthylene sulfonate formaldehyde condensate | ----- | 28.20 |
| TiO₂ pigment | ----- | 1670.00 |

| | | |
|---|---|---|
| ¹ "TETRONIC 701" | | |
| ² "DAXAD llKLS" | | |
| ³ 10.5 Micron; U.S. Patent No. 4,885,225 | | |
| Adhesive formulation I was coated to give a dry coating weight of 0.60 g/sq. ft. | | |

### Assembly of Proof

The element containing yellow pigment was laminated onto a receiver sheet made of water-proof paper (P-350, Schoeller Technical Paper Sales Inc.). The laminator utilized heated pressure rolls rotating at a speed of 60 inches/min. The laminate reached a temperature of about 180°F in the nip of the rolls. After the lamination step, the polyester carrier sheet was peeled away. The yellow photosensitive element was then imagewise exposed to a source of ultraviolet light through the appropriate color separation film. After exposure, the yellow image was developed. The formulation for the developer consisted of the following ingredients in the amounts indicated:

| Ingredient | Amount (g) |
|---|---|
| Deionized water | 97.9 |
| K₂CO₃ | 1.0 |
| NaHCO₃ | 1.0 |
| Surfactant("TRITON DF016:) | 0.10 |

The developer had a pH of about 9.7.

The cyan element was laminated onto the magenta image and imaged by repeating the foregoing procedure. The magenta element was laminated onto the composite image and imaged by repeating the foregoing procedure. The black element was laminated onto the three color composite image and imaged by repeating the foregoing procedure. The resulting assembly was a four-color surprint proof.

### Example 2

This example illustrates the effect of a barrier layer on the photosensitive element of this invention.

A multiple-layer construction similar to that of Example 1 was prepared, with the exception that the barrier layer was omitted. The images from Example 1 and from this example were evaluated for photospeed using a greyscale step wedge with 0.15 log E steps and a 20 second exposure time.

| Number of Steps | | | | |
|---|---|---|---|---|
| EXAMPLE | Yellow | Magenta | Cyan | Black |
| 1 | 1.5 | 4 | 2.5 | 1.5 |
| 2 | 0.5 | 2 | 0.0 | 0.5 |

These results demonstrate that the barrier layer significantly enhanced the photospeed of the construction.

### Example 3

This example illustrates the effect of a barrier layer on dot gain.

A multiple-layer construction similar to that of Example 1 was prepared, with the exception that the coating weight of the barrier layer was doubled to 0.020 g/sq.ft. The sample was laminated, exposed, and developed as in Example 1. The images of Example 1 and this example were compared for dot gain at the 40% midtone dot.

| Example | Dot Gain |
|---|---|
| 1 | 22% |
| 3 | 18% |

These results demonstrate that for a given exposure time, the dot gain of the proof can be controlled by controlling the thickness of the barrier layer.

### Example 4

This example illustrates a photosensitive element having no barrier layer and separate photosensitive and colorant layers. A photosensitive solution was coated over a release layer of the type used in Example 1. The formulation of the solution for preparing the photosensitive layer contained the following ingredients in the amounts indicated.

| Ingredient | Amount (g) |
|---|---|
| Methyl ethyl ketone | 5.00 |
| Acrylic resin ("JONCRYL 67") | 0.10 |
| Acrylic resin ("JONCRYL 586") | 0.35 |
| Diazo-oxide | 0.23 |

This solution was coated by means of an appropriate coating rod to give a dry coating weight of about 0.07 g/sq. ft.

An alkali soluble resin containing a single colorant was coated directly over the photosensitive layer. For each colorant, a sufficient amount of each formulation was coated by means of an appropriate coating rod over the photosensitive layer to provide the desired optical density. No barrier layer was used.

Formulations for each of the layers containing the colorant contained the following ingredients in the amounts indicated.

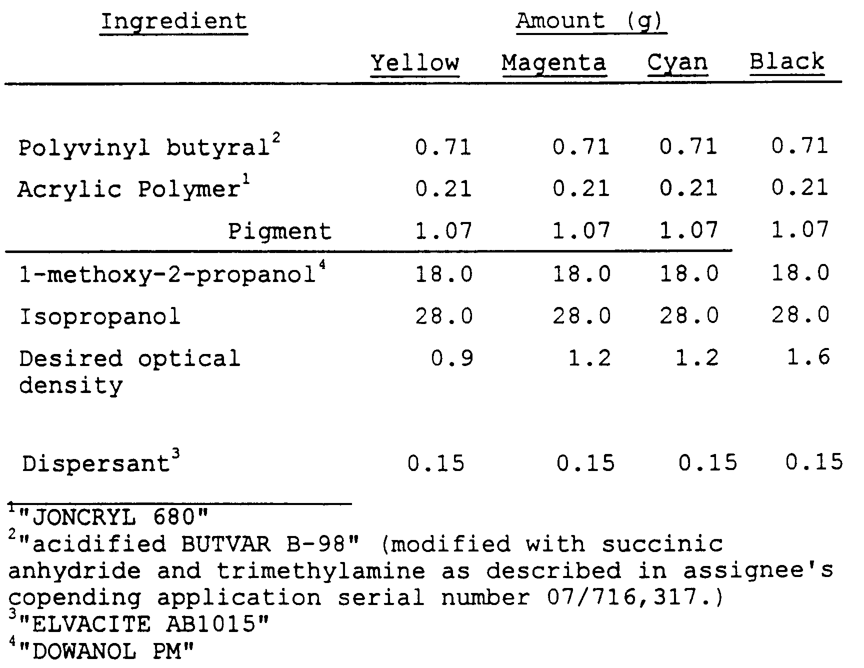

A layer containing a thermally activatable adhesive used in Example 1 was coated over the layer containing the colorant.

A four-color proof was assembled as in Example 1.

### Example 5

This example illustrates an overlay color proof, wherein there is no transfer of colorant to a receptor. Solutions of photosensitive material of the type used in Example 1 were coated directly onto untreated polyester film by means of an appropriate coating rod to obtain the following optical densities:

| Color | Optical Density |
|---|---|
| Yellow | 1.10 |
| Magenta | 1.41 |
| Cyan | 1.33 |
| Black | 1.75 |

Each element was exposed and developed in the manner as was used in Example 1. The imaged sheets were then assembled in register to make a four-color proof.

### Example 6

This example illustrates an overlay color proof, wherein there is no transfer of colorant to a receptor sheet. A developer having a relatively low pH was used.

A photosensitive layer containing a colorant was coated onto untreated polyester film. The formulation for preparing the photosensitive layer contained the following ingredients in the amounts indicated.

| Ingredient | Amounts by color | | | |
|---|---|---|---|---|
| | Magenta | Cyan | Yellow | Black |
| Diazo-oxide | 0.23 | 0.3 | 0.23 | 0.35 |
| Styrene/acrylic polymer¹ | 1.00 | 1.00 | 1.00 | 1.00 |
| Polyvinyl butyral² | 0.18 | 0.18 | 0.18 | 0.18 |
| Pigment | 0.27 | 0.18 | 0.15 | 0.36 |
| Acrylic Polymer³ | 0.05 | 0.05 | 0.05 | 0.05 |
| Methyl ethyl ketone | 4.50 | 4.50 | 4.50 | 4.50 |
| 1-methoxy-2-propanol⁴ | 4.50 | 4.50 | 4.50 | 4.50 |
| Coated color density | 1.41 | 1.33 | 1.10 | 1.75 |

| | | | | |
|---|---|---|---|---|
| ¹"JONCRYL 680" | | | | |
| ²"ACIDIFIED BUTVAR B-98" | | | | |
| ³"ELVACITE AB1015" | | | | |
| ⁴"DOWANOL PM" | | | | |

Each color solution was coated separately onto a polyesters sheet using the appropriate coating rod to achieve the proper color density.

The samples were then exposed in the same manner as was used in Example 1. The exposed samples were developed with a developer consisting of 99.0 g deionized water and 1.0 g NaHCO₃. The pH of the developer was 8.4.

The resulting imaged sheets were then assembled in register onto a white paper base to form a four color proof. The results showed that a developer having a relatively low pH can be used.

### Example 7

This example illustrates the preparation of a surprint color proof. A developer having a relatively low pH was used.

Solutions of photosensitive material containing the following ingredients in the amounts indicated was prepared.

| Ingredient | Amounts by color | | | |
|---|---|---|---|---|
| | Magenta | Cyan | Yellow | Black |
| Diazo-oxide | 0.120 | 0.160 | 0.120 | 0.180 |
| Styrene/acrylic polymer¹ | 0.270 | 0.270 | 0.270 | 0.270 |
| Polyvinyl butyral² | 0.024 | 0.024 | 0.024 | 0.024 |
| Pigment | 0.100 | 0.066 | 0.050 | 0.125 |
| Methyl ethyl ketone | 4.500 | 4.500 | 4.500 | 4.500 |
| 1-methoxy-2-propanol³ | 4.500 | 4.500 | 4.500 | 4.500 |
| Coated color density | 1.19 | 1.13 | 0.98 | 1.65 |

| | | | | |
|---|---|---|---|---|
| ¹"JONCRYL 680" | | | | |
| ²"ACIDIFIED BUTVAR B-98" | | | | |
| ³"DOWANOL PM" | | | | |

These solutions were coated over a release layer that had been coated onto a polyester film of the type used in Example 1. A barrier layer of the type used in Example 1 was coated over the photosensitive layer. A layer containing a thermally activatable adhesive of the type used in Example 1 was coated over the barrier layer.

The yellow sample was laminated and exposed in the same manner as was used in Example 1. The exposed sample was developed in the same manner as was used in Example 6 to provide a yellow image on a clear background. The magenta element was laminated onto the yellow image and imaged by repeating the foregoing procedure. The cyan element was laminated onto the yellow and magenta image and imaged by repeating the foregoing procedure. The black element was laminated onto the three color image and imaged by repeating the foregoing procedure.

### Example 8

This example illustrates the use of a photosensitive element, wherein the colorant is not in the photosensitive layer, to make a surprint color proof.

Photosensitive elements containing the release layer, photosensitive layer, and colorant layer of Example 4 were prepared. A solution for preparing a barrier layer of the type used in Example 1 was coated over the colorant-containing layer. A solution containing a thermally activatable adhesive of the type used in Example 1 was coated over the barrier layer. The sample was then laminated, exposed, and developed in the manner as was used in Example 1 to provide a clear image on a white background. A four-color proof was assembled. This example illustrates an embodiment where the colorant is not included in the colorant layer.

### Example 9

This example illustrates a photosensitive element, wherein the colorant is not in the photosensitive layer, for preparing an overlay color proof.

Colorant-containing solutions identical to those of Example 4 were coated directly onto polyester film. A solution of photosensitive material identical to that of Example 4 was coated over the colorant-containing layer. The samples were exposed and then developed in the developer used in Example 1. The imaged sheets were assembled in register to give a four-color proof.

A comparison element similar to that described in U.S. Patent 4,772,533 (having SMA as the adhesive, and having no barrier layer) was developed in the developer system used in the present invention at a pH of 9.7, near the top of the limits. The comparison plate showed very poor developability, with background areas having very high density levels.

## Claims

1. A positive-acting photosensitive element comprising:
(a) a release layer;
(b) a photosensitive layer comprising a positive-acting photosensitizer and a copolymer comprising acrylic acid or methacrylic acid moieties, which photosensitive layer is soluble in an aqueous solution having a pH of from about 8.4 to 9.8; and
(c) an adhesive layer.

2. The element of Claim 1, wherein said photosensitive layer further includes a pigment or a dye.

3. The element of Claim 1, wherein a pigment or dye is present in a binder as a separate colorant layer adjacent said photosensitive layer.

4. The element of any of claims 1 to 3, further including a barrier layer disposed between said photosensitive layer and said adhesive layer.

5. The element of Claim 4, wherein said barrier layer comprises a polymer selected from the group consisting of a) an acrylic resin hopolymer, b) an acrylic resin copolymer, and c) a copolymer of styrene and acrylic acid or methacrylic acid.

6. The element of Claim 4, wherein said barrier layer comprises a hydrophilic polymer.

7. The element of any of Claims 1 to 6, wherein said copolymer of layer b) has an acid number between 130 and 250.

8. The element of any of Claims 3 to 7, wherein said colorant layer comprises an acrylic resin.

9. The element of any of Claims 1 to 8, wherein said photosensitizer is a light-sensitive diazo compound.

10. The element of any of Claims 3 to 9, wherein said colorant layer comprises a copolymer of (a) styrene and (b) acrylic acid moieties or methacrylic acid moieties.

11. The element of any of Claims 1 to 10, wherein said photosensitive layer is capable of dissolving in a developer having a pH below about 9.5.

12. A positive-acting photosensitive element comprising:
(a) a photosensitive layer comprising a positive-acting photosensitizer and a copolymer comprising acrylic acid or methacrylic acid moieties, which layer is soluble in an aqueous solution having a pH of from about 8.4 to about 9.8; and
(b) a carrier layer

13. The element of Claim 12, wherein said photosensitive layer further includes a colorant.

14. The element of Claim 13, wherein a barrier layer is present over said photosensitive layer and that barrier layer comprises a copolymer of styrene and acrylic acid or methacrylic acid.
